# EUROPEAN PATENT APPLICATION

(11) **EP 3 869 540 A1**
(43) Date of publication of application: **25.08.2021**
(21) Application number: 18936905.1
(22) Date of filing: 16.10.2018
(51) Int. Cl.: H01L 21/56, H01L 25/07, H01L 25/18

(54) **POWER SEMICONDUCTOR DEVICE, AND METHOD FOR MANUFACTURING SAME**

(71) Applicant: Mitsubishi Electric Corporation, Tokyo 100-8310 (JP)
(72) Inventor: TANAKA Saburo, Tokyo 100-8310 (JP); KATO Masaki, Tokyo 100-8310 (JP); TAHARA Jun, Tokyo 100-8310 (JP); SHIMANO Tomoaki, Tokyo 100-8310 (JP); KAJIHARA Takanobu, Tokyo 100-8310 (JP)
(74) Representative: Hoffmann Eitle
(86) International application number: PCT/JP2018/038413
(87) International publication number: WO 2020/079743

(57) **Abstract**

A power semiconductor device (1) has a first gate breaking trace (63) and a second gate breaking trace (64) at a short-side-direction side surface (62) of a resin package (6). An upper gate (11a) and a lower gate (11b) of a mold (10) for molding the resin package (6) are located at a side of the short-side-direction side surface (62) of the resin package (6), and a plurality of cavities (12) are arranged such that longitudinal-direction side surfaces (61) of the adjacent resin packages (6) are opposed to each other. Thus, the number of power semiconductor devices (1) that can be molded at one time is increased, whereby productivity is improved.

## Description

### TECHNICAL FIELD

The present disclosure relates to a power semiconductor device and a method for manufacturing the same.

### BACKGROUND ART

In one of configurations of power semiconductor devices, a power semiconductor chip capable of switching is mounted on a lead frame formed in a wiring pattern shape and these are sealed in a resin package (molding resin). In the manufacturing process therefor, the lead frame on which the power semiconductor chip and the like are mounted is sealed with a molding resin by transfer molding or the like, and then, immediately after the power semiconductor device is taken out from a mold, gate breaking is performed to separate the power semiconductor device and the molding resin remaining in a gate of the mold from each other. Thus, a gate breaking trace remains at a side surface of the power semiconductor device.

The melted resin injected into the mold through the gate in the above resin sealing process flows into a last filled part of a cavity, in a state of being high in viscosity and low in wettability. Therefore, a defect such as filling deficiency or a void due to air entrapment is likely to occur at the last filled part, thus causing reduction in yield. In addition, the influence of stress during resin injection is great in the vicinity of the gate of the mold, so that the resin is likely to peel from the lead frame.

Therefore, in the conventional resin sealing process, the gate of the mold is located at a side of a longitudinal-direction side surface of the resin package and the melted resin is injected in a direction parallel to a short-side-direction side surface, so that the distance to the last filled part is shortened. In addition, since the gate is located at a side of the longitudinal-direction side surface of the resin package, the influence of stress during resin injection is reduced.

As a conventional manufacturing method for a semiconductor device of a resin-sealed type, for example, Patent Document 1 discloses a method in which a melted resin to be injected into a mold through a gate is pressure-injected in the extending direction of an irregularity surface formed in a cavity of the mold. Also in Patent Document 1, the gate is located at a side of a longitudinal-direction side surface of a resin package.

### CITATION LIST

### PATENT DOCUMENT

Patent Document 1: Japanese Laid-Open Patent Publication No. 2005-116556

### SUMMARY OF THE INVENTION

### PROBLEMS TO BE SOLVED BY THE INVENTION

As described above, in the conventional power semiconductor device, in the resin sealing process, the gate is located at a side of the longitudinal-direction side surface of the resin package, and therefore a gate breaking trace is formed at the longitudinal-direction side surface. Meanwhile, a plurality of gates are provided to a mold of a molding machine and a plurality of power semiconductor devices are molded at the same time. However, in the case where the gate is located at a side of the longitudinal-direction side surface of the resin package, there is a problem that the number of power semiconductor devices that can be molded at one time is fewer than in the case where the gate is located at a side of the short-side-direction side surface.

In order to increase the number of power semiconductor devices that can be molded at one time, it is necessary to increase the dimension in the longitudinal direction of the mold. However, this increases temperature variation in the mold surface, so that it becomes difficult to control resin molding property. As described above, it is not easy to increase the number of power semiconductor devices that can be molded at one time, and thus the conventional power semiconductor device has a problem of low productivity.

The present disclosure has been made to solve the above problem, and an object of the present disclosure is to provide a power semiconductor device and a manufacturing method therefor that enable increase in the number of power semiconductor devices that can be molded at one time, thus achieving improvement of productivity.

### SOLUTION TO THE PROBLEMS

A power semiconductor device according to the present disclosure is a power semiconductor device including: a lead frame having a plurality of areas electrically independent of each other; a power semiconductor chip capable of switching and mounted on a mounting surface of the lead frame; a wiring member electrically connecting the power semiconductor chip and the lead frame; and a resin package sealing the lead frame, the power semiconductor chip, and the wiring member, wherein the resin package has a longitudinal-direction side surface which is a longest side surface among a plurality of side surfaces thereof, and a short-side-direction side surface continuous to the longitudinal-direction side surface, and has a gate breaking trace at the short-side-direction side surface.

A method for manufacturing a power semiconductor device according to the present disclosure is a method for manufacturing a power semiconductor device including a resin package, the method including a step of placing a lead frame with a power semiconductor chip mounted on a mounting surface thereof, in a cavity of a mold, and then injecting a melted resin into the cavity through a gate, to mold the resin package, wherein the resin package has a longitudinal-direction side surface which is a longest side surface among a plurality of side surfaces thereof, and a short-side-direction side surface continuous to the longitudinal-direction side surface, and the gate is located at a side of the short-side-direction side surface of the resin package.

### EFFECT OF THE INVENTION

In the power semiconductor device according to the present disclosure, the gate breaking trace is formed at the short-side-direction side surface of the resin package, whereby the number of power semiconductor devices that can be molded at one time in the process of molding the resin packages is increased, thus making it possible to provide a power semiconductor device with high productivity and at low cost.

In the method for manufacturing the power semiconductor device according to the present disclosure, the gate of the mold is located at a side of the short-side-direction side surface of the resin package in the process of molding the resin package, whereby the number of power semiconductor devices that can be molded at one time can be increased, thus achieving improvement of productivity.

Objects, features, aspects, and effects of the present disclosure other than the above will become more apparent from the following detailed description with reference to the drawings.

### BRIEF DESCRIPTION OF THE DRAWINGS

[FIG. 1] FIG. 1 is a plan view and a side view showing a power semiconductor device according to embodiment 1.
[FIG. 2] FIG. 2 is a sectional view showing the power semiconductor device according to embodiment 1.
[FIG. 3] FIG. 3 is a sectional view illustrating a method for manufacturing the power semiconductor device according to embodiment 1.
[FIG. 4] FIG. 4 is a sectional view illustrating the method for manufacturing the power semiconductor device according to embodiment 1.
[FIG. 5] FIG. 5 is a schematic view illustrating the method for manufacturing the power semiconductor device according to embodiment 1 and a conventional power semiconductor device manufacturing method.
[FIG. 6] FIG. 6 is a schematic view illustrating a control-device-integrated rotary electric machine using the power semiconductor device according to embodiment 1, and a control-device-integrated rotary electric machine using a conventional power semiconductor device.
[FIG. 7] FIG. 7 is a plan view illustrating a method for manufacturing a power semiconductor device according to embodiment 2.
[FIG. 8] FIG. 8 is a plan view illustrating a method for manufacturing a power semiconductor device according to embodiment 2.
[FIG. 9] FIG. 9 is a plan view showing a power semiconductor device according to embodiment 3.

### DESCRIPTION OF EMBODIMENTS

### Embodiment 1

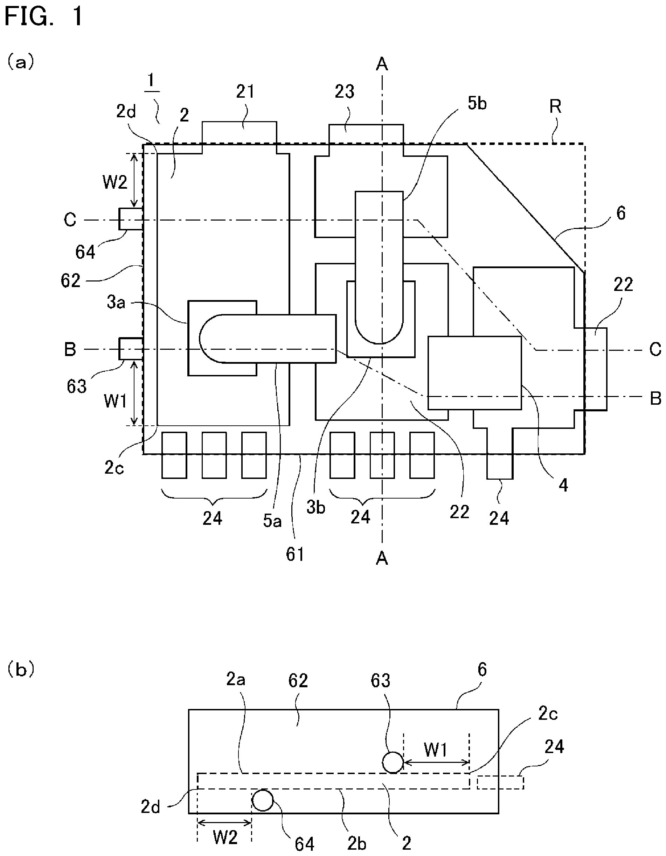

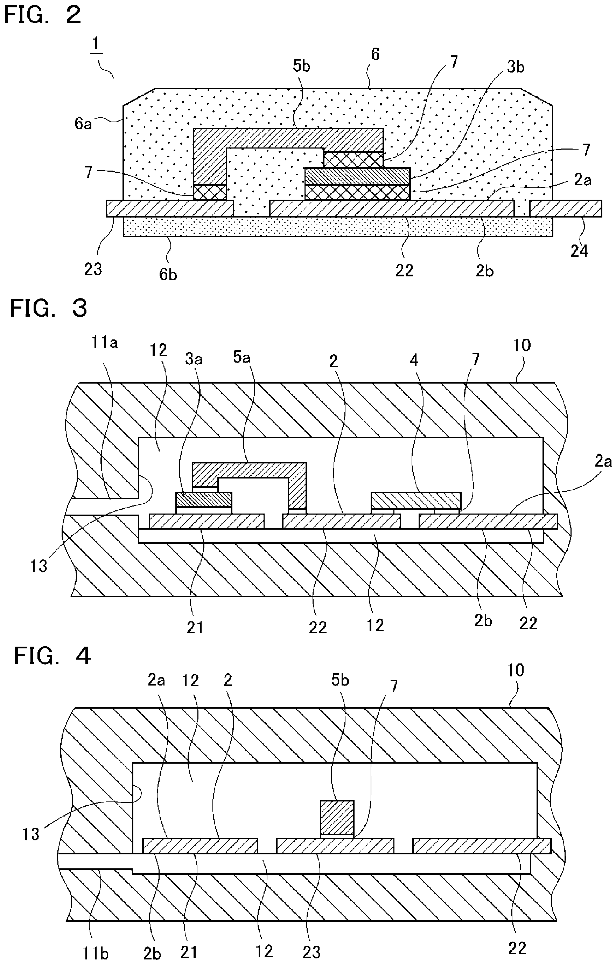

Hereinafter, a power semiconductor device according to embodiment 1 will be described with reference to the drawings. FIG. 1(a) and FIG. 1(b) are a plan view and a side view showing the power semiconductor device according to embodiment 1, and FIG. 2 is a sectional view at a part indicated by A-A in FIG. 1(a). In the drawings, the same or corresponding parts are denoted by the same reference characters.

As shown in FIG. 1(a), a power semiconductor device 1 according to embodiment 1 includes a lead frame 2 made of metal, power semiconductor chips 3a, 3b capable of switching, a resistor 4 for current detection, inner leads 5a, 5b which are wiring members made of metal, and a resin package 6 which is a molding resin covering these. The lead frame 2 is a plate member made of an alloy using copper, aluminum, or the like as a base material, and is formed in a wiring pattern shape by etching work or press work. On the surface of the lead frame 2, the metal of the base material may be exposed, or at least a part of the surface of the lead frame 2 may be coated with a metal plating such as gold, silver, nickel, or tin.

The lead frame 2 has a plurality of areas electrically independent of each other, and in the example shown in FIG. 1, includes a P potential lead 21 on which the power semiconductor chip 3a is mounted, an AC potential lead 22 on which the power semiconductor chip 3b is mounted, and an N potential lead 23 on which no power semiconductor chip is mounted. The AC potential lead 22 on which the power semiconductor chip 3b is mounted is electrically connected to an AC potential lead 22 on which no power semiconductor chip is mounted, via a resistor 4 such as a shunt resistor. It is noted that the number, the shape, and the arrangement of the plurality of areas of the lead frame 2, the number and the arrangement of the power semiconductor chips, and the like are not limited to the above.

As shown in FIG. 2, the lead frame 2 has main surfaces opposite to each other, one of which is a mounting surface 2a and the other one of which is a heat dissipation surface 2b. The power semiconductor chips 3a, 3b, the inner leads 5a, 5b, the resistor 4, and the like are mounted on the mounting surface 2a. In addition, a heatsink (not shown) is joined to the heat dissipation surface 2b of the lead frame 2 via a heat-dissipation-surface-side resin 6b and an insulating adhesive agent having high thermal conductivity.

As the power semiconductor chips 3a, 3b, for example, metal-oxide semiconductor field-effect transistors (MOSFET) are used. However, without limitation thereto, insulated gate bipolar transistors (IGBT) may be used. For the base material of the power semiconductor chips 3a, 3b, silicon, silicon carbide, silicon nitride, gallium nitride, gallium arsenide, or the like is used.

The power semiconductor chips 3a, 3b each have an upper surface electrode, i.e., a source electrode, a gate portion, and a gate electrode on a chip upper surface, and have a lower surface electrode on a chip lower surface (all not shown). In the example shown in FIG. 1(a), the upper surface electrode of the power semiconductor chip 3a is electrically connected to the AC potential lead 22 via the inner lead 5a, and the upper surface electrode of the power semiconductor chip 3b is electrically connected to the N potential lead 23 via the inner lead 5b. In addition, the gate electrode is connected to a gate terminal formed from a part of the lead frame 2, via a wire bond (not shown).

Between the upper surface electrodes of the power semiconductor chips 3a, 3b and the inner leads 5a, 5b, between the inner leads 5a, 5b and the lead frame 2, and between the lower surface electrodes and the lead frame 2, connections are made via solder 7 which is an electrically conductive joining member. The solder 7 at the above plurality of joining parts can be joined through a collective heating treatment by a reflow device or the like.

It is noted that strain can occur due to temperature change or the like in use of the power semiconductor device 1, so that the durability may differ among the plurality of joining parts. In this case, solders 7 having different compositions may be used for the respective joining parts. In addition, the electrically conductive joining member is not limited to the solder 7, but may be an electrically conductive resin paste, a sintering paste, or the like. In the case where the upper surface electrodes and the inner leads 5a, 5b are joined by the solder 7, a nickel plating is applied to the upper surface electrodes so as to be adapted to soldering.

The lead frame 2, the power semiconductor chips 3a, 3b, the resistor 4, the inner leads 5a, 5b, and the like are sealed by the resin package 6. The resin package 6 is formed in a substantially rectangular parallelepiped shape having main surfaces opposite to each other and four or more side surfaces connecting therebetween. The resin package 6 shown in FIG. 1(a) has five side surfaces and therefore is not a rectangular parallelepiped shape, but in FIG. 1(a), a dotted line indicated by R represents the outer shape when the resin package 6 is regarded as a rectangular parallelepiped shape. The plurality of side surfaces are substantially perpendicular to the main surfaces of the resin package 6.

The resin package 6 has a longitudinal-direction side surface 61 which is the longest side surface among the plurality of side surfaces, and a short-side-direction side surface 62 continuous to the longitudinal-direction side surface 61. In the case where the resin package 6 has a rectangular parallelepiped shape, the resin package 6 has two pairs of the longitudinal-direction side surfaces 61 and the short-side-direction side surfaces 62. Further, the resin package 6 has a first gate breaking trace 63 and a second gate breaking trace 64 (collectively referred to as gate breaking traces) at the short-side-direction side surface 62. In the example shown in FIG. 1(a), the gate breaking traces are formed at the short-side-direction side surface 62 that is the longer one of the two side surfaces continuous to the longitudinal-direction side surface 61.

As shown in FIG. 2, the resin package 6 includes a mounting-surface-side resin 6a sealing the mounting surface 2a of the lead frame 2, and the heat-dissipation-surface-side resin 6b sealing the heat dissipation surface 2b opposite to the mounting surface 2a. The mounting-surface-side resin 6a and the heat-dissipation-surface-side resin 6b are molding resins such as epoxy resin. As the mounting-surface-side resin 6a, a molding resin for a general integrated circuit is used. As the heat-dissipation-surface-side resin 6b, a high-heat-dissipation resin having higher thermal conductivity (for example, about 3 W/m·K to 12 W/m·K) than the mounting-surface-side resin 6a is used. The mounting-surface-side resin 6a has the first gate breaking trace 63, and the heat-dissipation-surface-side resin 6b has the second gate breaking trace 64.

The first gate breaking trace 63 and the second gate breaking trace 64 are located so as not to overlap each other in a direction perpendicular to the main surface (e.g., mounting surface 2a) of the lead frame 2. As shown in FIG. 1(b), in a view when the resin package 6 is seen through from the short-side-direction side surface 62, a distance W1 between the first gate breaking trace 63 and a corner 2c of the lead frame 2 closest to the first gate breaking trace 63 is equal to or greater than 1 mm (W1 ≥ 1 mm).

Similarly, a distance W2 between the second gate breaking trace 64 and a corner 2d of the lead frame 2 closest to the second gate breaking trace 64 is equal to or greater than 1 mm (W2 ≥ 1 mm). As described above, the gate positions are distant from the corners 2c, 2d of the lead frame 2 by a predetermined distance or longer, whereby stress concentration on the corners 2c, 2d during resin injection can be prevented and thus peeling of the molding resin can be suppressed. It is noted that, although the predetermined distance is set to 1 mm in embodiment 1, the predetermined distance may be changed as appropriate in accordance with the thickness and the width of the lead frame 2, the pressure in resin injection, or the like.

A method for manufacturing the power semiconductor device 1 will be described with reference to FIG. 3, FIG. 4, FIG. 5(a), and FIG. 5(b). FIG. 3 and FIG. 4 illustrate the method for manufacturing the power semiconductor device according to embodiment 1, and show a state after the lead frame (referred to as circuit assembly) with the power semiconductor chip mounted on the mounting surface thereof is placed in a cavity of a mold and before a melted resin is injected. The circuit assembly shown in FIG. 3 corresponds to a cross section at a part indicated by B-B in FIG. 1(a), and the circuit assembly shown in FIG. 4 corresponds to a cross section at a part indicated by C-C in FIG. 1(a).

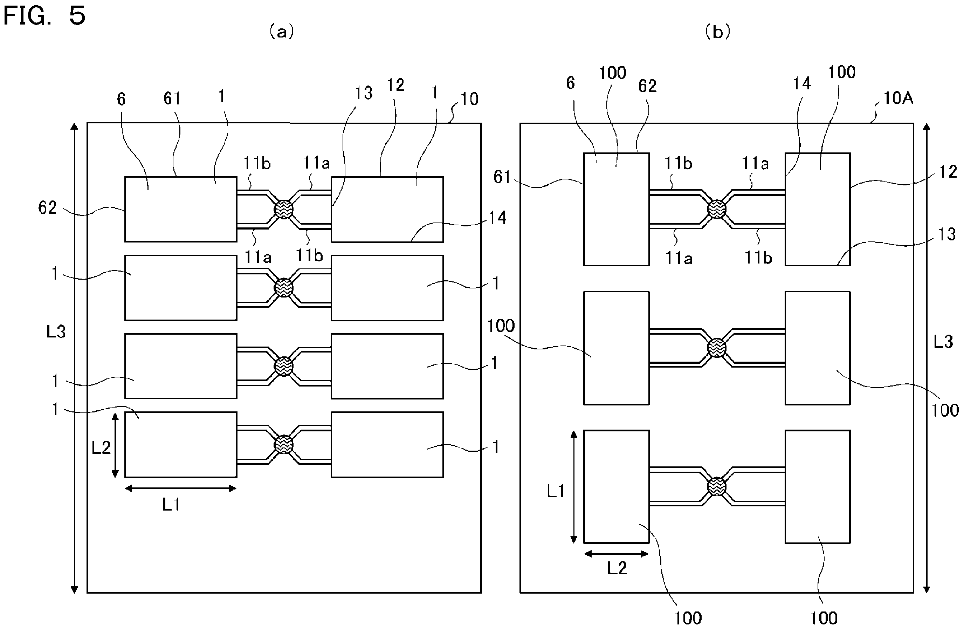

FIG. 5(a) is a schematic view illustrating the method for manufacturing the power semiconductor device according to embodiment 1, and shows a state before the power semiconductor devices 1 are taken out from a mold 10. As a comparative example, FIG. 5(b) is a schematic view illustrating a conventional power semiconductor device manufacturing method and shows a state before conventional power semiconductor devices 100 are taken out from a conventional mold 10A. In FIG. 5(a) and FIG. 5(b), the shape of the resin package 6 is assumed to be a rectangular parallelepiped shape.

The method for manufacturing the power semiconductor device 1 according to embodiment 1 includes a process in which a circuit assembly obtained by mounting the power semiconductor chips 3a, 3b, the inner leads 5a, 5b, and the like on the mounting surface 2a of the lead frame 2 is placed at a predetermined position in the cavity 12 of the mold 10, and then a melted resin is injected into the cavity 12 through the gate to mold the resin package 6.

The mold 10 has an upper gate 11a as a first gate and a lower gate 11b as a second gate (these are collectively referred to as gates). The upper gate 11a and the lower gate 11b are located so as not to overlap each other in a direction perpendicular to the mounting surface 2a of the lead frame 2. In addition, as described above, the gate positions are distant by a predetermined distance (in the embodiment, 1 mm) from the corners of the lead frame 2 placed at the predetermined position in the cavity 12.

As shown in FIG. 3, through the upper gate 11a, a melted resin (mounting-surface-side resin 6a) for sealing the mounting surface 2a of the lead frame 2 is injected into the cavity 12. In addition, as shown in FIG. 4, through the lower gate 11b, a melted resin (heat-dissipation-surface-side resin 6b) for sealing the heat dissipation surface 2b is injected into the cavity 12. These gates open on the inner wall 13 of the mold 10 corresponding to the short-side-direction side surface 62 of the resin package 6.

The mounting-surface-side resin 6a and the heat-dissipation-surface-side resin 6b are individually injected at times shifted from each other through the upper gate 11a and the lower gate 11b, respectively. Thus, different resins can be used for the mounting-surface-side resin 6a and the heat-dissipation-surface-side resin 6b, and a resin having higher heat dissipation property than the mounting-surface-side resin 6a can be used as the heat-dissipation-surface-side resin 6b. In addition, after first resin injection, second resin injection can be performed through the lower gate 11b, without removing the mounting-surface-side resin 6a remaining in the upper gate 11a.

After the resin package 6 is molded, the power semiconductor device 1 is taken out from the mold 10, and immediately after this, gate breaking is performed to separate the power semiconductor device 1 and the molding resin remaining in the gate from each other. A gate breaking trace remains at the resin package 6 of the power semiconductor device 1 after the gate breaking. Thereafter, parts unnecessary for electric wiring are removed from the lead frame 2. Thus, the lead frame 2 is separated to form the P potential lead 21, the AC potential lead 22, the N potential lead 23, a signal terminal 24, and the like which are electrically independent of each other.

The mold 10 includes a plurality of cavities 12 that allow a plurality of resin packages 6 to be molded at the same time. In the case of the mold 10 in embodiment 1, as shown in FIG. 5(a), the plurality of cavities 12 are arranged such that the longitudinal-direction side surfaces 61 of the adjacent resin packages 6 are opposed to each other. That is, inner walls 14 of the mold 10 corresponding to the longitudinal-direction side surfaces 61 of the resin packages 6 are opposed to each other.

On the other hand, in the case of the mold 10A for manufacturing the conventional power semiconductor device 100 in the comparative example shown in FIG. 5(b), the plurality of cavities 12 are arranged such that the short-side-direction side surfaces 62 of the adjacent resin packages 6 are opposed to each other. That is, the inner walls 13 corresponding to the short-side-direction side surfaces 62 of the resin packages 6 are opposed to each other.

The dimension of the longitudinal-direction side surface 61 of the resin package 6 is denoted by L1, the dimension of the short-side-direction side surface 62 is denoted by L2 (L1 > L2), and the dimension in the longitudinal direction of the mold 10 is denoted by L3. In this case, in the mold 10 shown in FIG. 5(a), it is found through simple calculation that approximately (L2/L3×2) power semiconductor devices 1 can be molded at one time. On the other hand, in the conventional mold 10A shown in FIG. 5(b), it is found through simple calculation that the number of power semiconductor devices 100 that can be molded at one time is approximately (L1/L3×2). Thus, in the case of the power semiconductor device 1, the gates are located at a side of the short-side-direction side surface 62 of the resin package 6, whereby effective arrangement can be made in the mold 10 and the number of power semiconductor devices that can be molded at one time is larger than in the case of the conventional power semiconductor device 100.

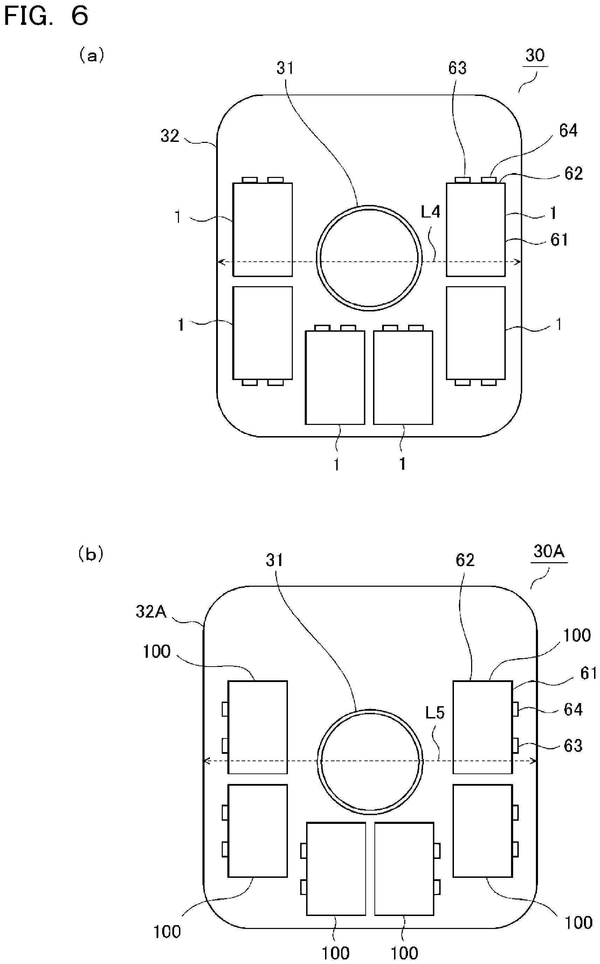

In addition, in the case of using the power semiconductor device 1 of embodiment 1 for a control device of a control-device-integrated rotary electric machine, effective arrangement is possible by utilizing the structure in which the gate breaking traces are formed at the short-side-direction side surface 62, whereby size reduction of the control device can be achieved. FIG. 6(a) is a schematic view illustrating the control-device-integrated rotary electric machine using the power semiconductor device according to embodiment 1, and FIG. 6(b) is a schematic view illustrating a control-device-integrated rotary electric machine using a conventional power semiconductor device. In FIG. 6(a) and FIG. 6(b), the shape of the resin package is assumed to be a rectangular parallelepiped shape and the signal terminal and the like are not shown. In addition, parts other than the power semiconductor devices are not shown.

The control-device-integrated rotary electric machine is obtained by integrating a rotary electric machine (not shown) and a control device 30 for controlling the rotary electric machine, and the control device 30 includes the power semiconductor device 1 (power module) having a switching element for energizing a stator winding, a field module having a switching element for energizing a field winding of a rotor, and a control board for controlling these. The power semiconductor device 1 and the field module are mounted on a heatsink and housed in a case 32 made of resin. The case 32 is formed to be hollow in an area around a shaft 31. The detailed configuration of the control device 30 is not directly relevant to the present disclosure and therefore the description thereof is omitted.

As shown in FIG. 6(a), in the control device 30 with six power semiconductor devices 1 arranged, the dimension in the radial direction of the case 32 of the control device 30 is denoted by L4 in the drawing. On the other hand, as shown in FIG. 6(b), in a control device 30A with six conventional power semiconductor devices 100 arranged, the dimension in the radial direction of a case 32A of the control device 30A is denoted by L5 in the drawing, and L4 is smaller than L5. The arrangement method for the power semiconductor devices 1 shown in FIG. 6(a) is merely an example, and the number of the power semiconductor devices 1 and the arrangement method therefor in the control device 30 are not limited to the above example.

As described above, according to embodiment 1, the gate breaking traces are formed at the short-side-direction side surface 62 of the resin package 6, whereby the number of power semiconductor devices that can be molded at one time in a process for molding the resin packages 6 is increased, thus making it possible to provide the power semiconductor device 1 with high productivity and at low cost. In addition, the distances between the gate breaking traces and the corners of the lead frame 2 closest to the gate breaking traces are set to be equal to or greater than a predetermined distance (1 mm), whereby peeling of the molding resin due to stress concentration on the corners of the lead frame 2 during resin injection can be suppressed, and thus the power semiconductor device 1 with high reliability can be obtained.

In the method for manufacturing the power semiconductor device according to embodiment 1, the gates of the mold 10 are located at a side of the short-side-direction side surface 62 of the resin package 6, whereby a plurality of cavities 12 can be arranged such that the longitudinal-direction side surfaces 61 of the adjacent resin packages 6 are opposed to each other. Thus, the number of power semiconductor devices 1 that can be molded at one time is increased, so that the productivity is improved. In addition, the upper gate 11a and the lower gate 11b are located so as not to overlap each other in a direction perpendicular to the mounting surface 2a of the lead frame 2, whereby stress on the lead frame 2 during resin injection can be distributed without being concentrated, so that peeling of the molding resin can be suppressed.

The mounting-surface-side resin 6a and the heat-dissipation-surface-side resin 6b are injected at times shifted from each other through the upper gate 11a and the lower gate 11b, respectively. Thus, it becomes possible to select a high-heat-dissipation resin as the heat-dissipation-surface-side resin 6b, whereby the power semiconductor device 1 having high heat dissipation property can be provided. Further, after first resin injection, second resin injection can be performed through the lower gate 11b without removing the mounting-surface-side resin 6a remaining in the upper gate 11a. Thus, the manufacturing can be performed with decreased processing steps and productivity can be improved.

### Embodiment 2

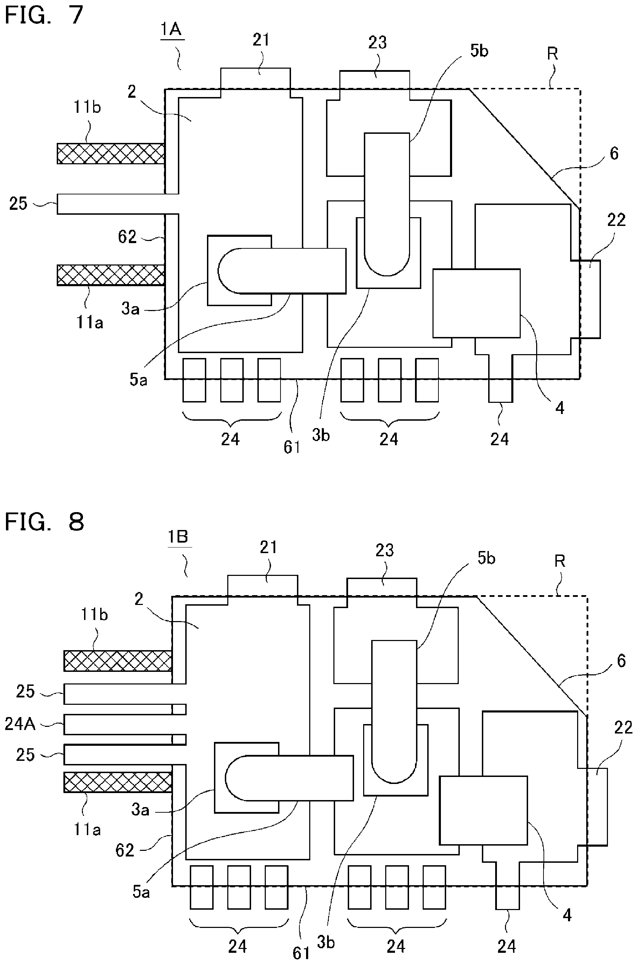

FIG. 7 and FIG. 8 are plan views illustrating methods for manufacturing power semiconductor devices according to embodiment 2. FIG. 7 and FIG. 8 show power semiconductor devices 1A, 1B in a state before molding resins remaining inside the upper gate 11a and the lower gate 11b are separated. The power semiconductor devices 1A, 1B according to embodiment 2 are modifications of the power semiconductor device 1 according to the above embodiment 1. Therefore, the description of components is omitted and only a difference will be described.

In general, in a mold for molding a resin package, a melted resin flows into a last filled part, in a state of being high in viscosity and low in wettability, so that a void due to air entrapment is likely to occur at the last filled part. Therefore, it is preferable that the distance from a gate to the last filled part is short. However, in the case where the gate of the mold 10 is located at a side of the short-side-direction side surface 62 of the resin package 6 as in the above embodiment 1, the distance from the gate to the last filled part becomes longer than in the conventional case.

In order to prevent occurrence of a void in the above embodiment 1, it is necessary to increase the molding pressure as compared to the conventional case, but when the molding pressure is increased, resin leakage from the gate is more likely to occur. In addition, in the case where the gates are located at a side of the short-side-direction side surface 62 of the resin package 6, the influence of stress during resin injection becomes greater than in the case where the gates are located at a side of the longitudinal-direction side surface 61, and further, increasing the molding pressure also increases the influence of stress during resin injection. That is, in the case where the gates are located at a side of the short-side-direction side surface 62 of the resin package 6, it is necessary to suppress the influence of resin leakage and the influence of stress during resin injection.

Considering the above, in the power semiconductor device 1A according to embodiment 2, as shown in FIG. 7, a part unnecessary for electric wiring, of a peripheral portion of the lead frame 2, is provided as a suspension pin 25 between the upper gate 11a and the lower gate 11b of the mold 10. In a process for molding the resin package 6, the suspension pin 25 is fixed to the mold 10 and supports a semiconductor chip mounted part of the lead frame 2. Thus, it is possible to reduce stress applied to the lead frame 2 during resin injection, whereby peeling of the molding resin can be suppressed.

In addition, since the suspension pin 25 is located between the upper gate 11a and the lower gate 11b, the mounting-surface-side resin 6a leaked from the upper gate 11a can be prevented from flowing into the lower gate 11b. That is, the suspension pin 25 serves as a dam for damming the melted resin leaked from the upper gate 11a. Thus, the lower gate 11b can be prevented from being clogged, whereby productivity is improved. Further, since a signal terminal is not present between the upper gate 11a and the lower gate 11b, the molding resins remaining in the gates, and the suspension pin 25, can be cut at the same time, and the structure of the mold 10 can be a simple shape.

In the power semiconductor device 1B shown in FIG. 8, a terminal formation portion 24A which is a part to be a terminal at a periphery of the lead frame 2 is provided between the upper gate 11a and the lower gate 11b of the mold 10, and suspension pins 25 are provided between the terminal formation portion 24A and the upper gate 11a and between the terminal formation portion 24A and the lower gate 11b. In the case of the configuration shown in FIG. 8, the molding resins remaining in the gates are cut immediately after molding, and the suspension pins 25 are cut in a subsequent process.

In the power semiconductor device 1B, the suspension pins 25 are provided on both sides of the terminal formation portion 24A, whereby the resins leaked from the gates on both sides can be prevented from adhering to the terminal formation portion 24A. In addition, since two suspension pins 25 and one terminal formation portion 24A are provided between the upper gate 11a and the lower gate 11b, stress applied to the lead frame 2 during resin injection can be more reduced than in the power semiconductor device 1A shown in FIG. 7.

According to embodiment 2, in addition to the same effects as in the above embodiment 1, the suspension pin 25 is provided between the upper gate 11a and the lower gate 11b, whereby the influence of resin leakage and the influence of stress during resin injection can be suppressed. Thus, the manufacturing process is simplified and peeling of the molding resin is suppressed, whereby productivity and reliability are improved.

### Embodiment 3

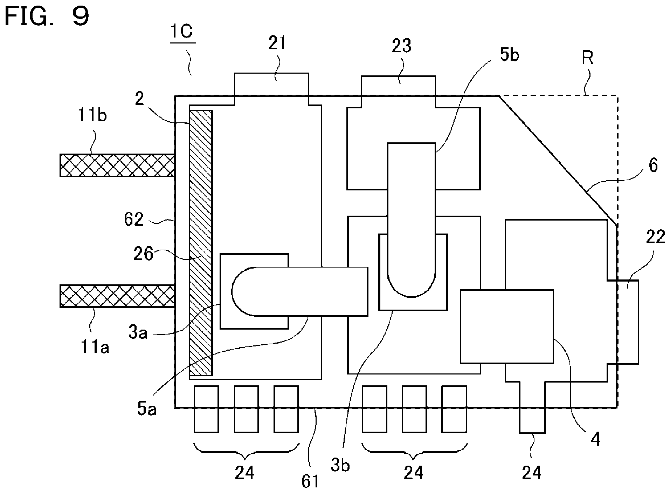

FIG. 9 is a plan view showing a power semiconductor device according to embodiment 3. FIG. 9 shows a power semiconductor device 1C in a state before molding resins remaining inside the upper gate 11a and the lower gate 11b are separated. The power semiconductor device 1C according to embodiment 3 is a modification of the power semiconductor device 1 according to the above embodiment 1. Therefore, the description of components is omitted and only a difference will be described.

In the above embodiment 2, the suspension pin 25 is provided between the upper gate 11a and the lower gate 11b, whereby the influence of stress during resin injection is suppressed and thus peeling of the molding resin is suppressed. On the other hand, in the power semiconductor device 1C according to embodiment 3, as shown in FIG. 9, a surface modified area 26 which has higher adhesion property with the resin package 6 than the other area of the lead frame 2 is provided at a peripheral portion of the lead frame 2 adjacent to the short-side-direction side surface 62 of the resin package 6.

The surface modified area 26 is obtained by roughening the surface of the lead frame 2 through a surface treatment such as a laser treatment or a chemical treatment, for example. In addition, a recess may be formed on the surface of the lead frame 2 so as to obtain an anchor effect. Alternatively, on the surface modified area 26, the base material, i.e., copper, of the lead frame 2 may be exposed without providing a metal plating thereon.

According to embodiment 3, in addition to the same effects as in the above embodiment 1, the lead frame 2 has the surface modified area 26 at a periphery adjacent to the short-side-direction side surface 62 of the resin package 6, whereby peeling of the molding resin due to stress during resin injection can be suppressed, and thus productivity and reliability are improved.

Although the disclosure is described above in terms of various exemplary embodiments and implementations, it should be understood that the various features, aspects, and functionality described in one or more of the individual embodiments are not limited in their applicability to the particular embodiment with which they are described, but instead can be applied, alone or in various combinations to one or more of the embodiments of the disclosure.

It is therefore understood that numerous modifications which have not been exemplified can be devised without departing from the scope of the present disclosure. For example, at least one of the constituent components may be modified, added, or eliminated. At least one of the constituent components mentioned in at least one of the preferred embodiments may be selected and combined with the constituent components mentioned in another preferred embodiment.

### DESCRIPTION OF THE REFERENCE CHARACTERS

- 1, 1A, 1B, 1C, 100: power semiconductor device
- 2: lead frame
- 2a: mounting surface
- 2b: heat dissipation surface
- 2c, 2d: corner
- 3a, 3b: power semiconductor chip
- 4: resistor
- 5a, 5b: inner lead
- 6: resin package
- 6a: mounting-surface-side resin
- 6b: heat-dissipation-surface-side resin
- 7: solder
- 10, 10A: mold
- 11a: upper gate
- 11b: lower gate
- 12: cavity
- 13, 14: inner wall
- 21: P potential lead
- 22: AC potential lead
- 23: N potential lead
- 24: signal terminal
- 24A: terminal formation portion
- 25: suspension pin
- 26: surface modified area
- 30, 30A: control device
- 31: shaft
- 32, 32A: case
- 61: longitudinal-direction side surface
- 62: short-side-direction side surface
- 63: first gate breaking trace
- 64: second gate breaking trace

## Claims

1. A power semiconductor device comprising:
a lead frame having a plurality of areas electrically independent of each other;
a power semiconductor chip capable of switching and mounted on a mounting surface of the lead frame;
a wiring member electrically connecting the power semiconductor chip and the lead frame; and
a resin package sealing the lead frame, the power semiconductor chip, and the wiring member, wherein
the resin package has a longitudinal-direction side surface which is a longest side surface among a plurality of side surfaces thereof, and a short-side-direction side surface continuous to the longitudinal-direction side surface, and has a gate breaking trace at the short-side-direction side surface.

2. The power semiconductor device according to claim 1, wherein
the resin package includes a mounting-surface-side resin sealing the mounting surface of the lead frame, and a heat-dissipation-surface-side resin sealing a heat dissipation surface opposite to the mounting surface.

3. The power semiconductor device according to claim 2, wherein
the gate breaking trace includes a first gate breaking trace and a second gate breaking trace,
the mounting-surface-side resin has the first gate breaking trace, and
the heat-dissipation-surface-side resin has the second gate breaking trace.

4. The power semiconductor device according to claim 3, wherein
the first gate breaking trace and the second gate breaking trace are located so as not to overlap each other in a direction perpendicular to the mounting surface of the lead frame.

5. The power semiconductor device according to any one of claims 1 to 4, wherein
the resin package has four or more side surfaces, and the short-side-direction side surface is a longer one of two side surfaces continuous to the longitudinal-direction side surface.

6. The power semiconductor device according to any one of claims 1 to 5, wherein
in a view when the resin package is seen through from the short-side-direction side surface, a distance between the gate breaking trace and a corner of the lead frame closest to the gate breaking trace is equal to or greater than 1 mm.

7. The power semiconductor device according to any one of claims 1 to 6, wherein
the lead frame has, at a peripheral portion adjacent to the short-side-direction side surface of the resin package, a surface modified area having higher adhesion property with the resin package, than another area of the lead frame.

8. A method for manufacturing a power semiconductor device including a resin package, the method comprising a step of placing a lead frame with a power semiconductor chip mounted on a mounting surface thereof, in a cavity of a mold, and then injecting a melted resin into the cavity through a gate, to mold the resin package, wherein
the resin package has a longitudinal-direction side surface which is a longest side surface among a plurality of side surfaces thereof, and a short-side-direction side surface continuous to the longitudinal-direction side surface, and
the gate is located at a side of the short-side-direction side surface of the resin package.

9. The method for manufacturing the power semiconductor device according to claim 8, wherein
the mold has a plurality of the cavities that allow a plurality of the resin packages to be molded at a same time, and
the plurality of cavities are arranged such that the longitudinal-direction side surfaces of the adjacent resin packages are opposed to each other.

10. The method for manufacturing the power semiconductor device according to claim 8 or 9, wherein
the gate includes a first gate for injecting a mounting-surface-side resin for sealing the mounting surface of the lead frame, and a second gate for injecting a heat-dissipation-surface-side resin for sealing a heat dissipation surface opposite to the mounting surface.

11. The method for manufacturing the power semiconductor device according to claim 10, wherein
the first gate and the second gate are located so as not to overlap each other in a direction perpendicular to the mounting surface of the lead frame.

12. The method for manufacturing the power semiconductor device according to claim 10 or 11, wherein
the mounting-surface-side resin and the heat-dissipation-surface-side resin are injected at times shifted from each other.

13. The method for manufacturing the power semiconductor device according to any one of claims 10 to 12, wherein
a part unnecessary for electric wiring, of a peripheral portion of the lead frame is provided as a suspension pin between the first gate and the second gate.

14. The method for manufacturing the power semiconductor device according to claim 13, wherein
a terminal formation portion of the lead frame is provided between the first gate and the second gate, and
the suspension pins are provided between the terminal formation portion and the first gate and between the terminal formation portion and the second gate.
